# EUROPÄISCHE PATENTSCHRIFT

(11) **EP 2 322 309 B1**
(45) Veröffentlichungstag und Bekanntmachung des Hinweises auf die Patenterteilung: **02.11.2016**
(21) Anmeldenummer: 10014478.1
(22) Anmeldetag: 11.11.2010
(51) Int. Cl.: B23K 15/08, B23K 15/10, H01J 37/31

(54) **Verfahren und Vorrichtungen zum thermischen Bearbeiten von Werkstoffen mit einem Elektronenstrahl und Gas**
Methods of and devices for thermal processing of workpieces with an electron beam and gas
Procédés et dispositifs de traitement thermique de matières premières à l'aide d'un rayonnement à électrons et du gaz

(30) Priorität: 13.11.2009 DE 102009052807
(43) Veröffentlichungstag der Anmeldung: 18.05.2011
(73) Patentinhaber: Ruchay, Wilfried, 17039 Trollenhagen (DE)
(72) Erfinder: Bach, Friedrich Wilhelm, 30916 Isernhagen (DE); Beniyash, Alexander, 30165 Hannover (DE); Hassel, Thomas, 30419 Hannover (DE); Konya, Rudolf, 30419 Hannover (DE); Murray, Nils, 30855 Langenhagen (DE); Ruchay, Wilfried, 17039 Trollenhagen (DE)
(74) Vertreter: Voss, Karl-Heinz

(56) Entgegenhaltungen:
- WO-A2-2005/011907
- US-A- 3 175 073
- DATABASE WPI Week 197418 Thomson Scientific, London, GB; AN 1974-33900V XP002623484, -& JP 49 014976 B (Y. ARATA) 11. April 1974 (1974-04-11)

## Beschreibung

Die Erfindung betrifft Verfahren und Vorrichtungen zur Durchführung des Verfahrens zum thermischen Trennen von Werkstoffen, insbesondere Schneiden von Metall, mit einem Elektronenstrahl gemäß dem Oberbegriff der Ansprüche 1-2 und 4-6 (siehe, z. B. DE38 01 068). Das Verfahren und die Vorrichtung sind bei Atmosphärendruck einsetzbar.

### Stand der Technik

Es sind verschiedene thermische Schneidverfahren/ Trennverfahren für metallische und andere Werkstoffe bekannt, wie das Brennschneiden mit einem Sauerstoff- und Acetylenbrenngasstrahl, Plasmagasstrahl und das Laserbrennschneiden. Bei diesen Verfahren wird der Werkstoff durch den heißen Gasstrahl, bzw. Laserstrahl örtlich geschmolzen und das geschmolzene Material durch den Schneidstrahl, bzw. einen zusätzlichen Gasstrahl ausgeblasen. Mit dem zusätzlichen Gasstrahl wird beim herkömmlichen Brennschneiden das Material gleichzeitig oxydiert, so dass Schlacke mit geringer Festigkeit entsteht. Entlang der behandelten Schneid- oder Trennfuge verbleiben zumindest an den Kanten Schlackereste.
Auch aus anderen Gründen ist die Oberfläche der geschnittenen Werkstoffseiten unregelmäßig und muss gegebenenfalls nachträglich mechanisch geglättet werden.

Zum sicheren Trennen des Werkstoffes und Ausblasen der Schlacke ist eine gewisse Fugenbreite erforderlich, wofür entsprechende Gasmengen bzw. Energie notwendig sind. Eine höhere Schneidstrahltemperatur bewirkt eine schnellere Erwärmung und damit geringere Wärmeausbreitung im Werkstoff, was eine schmalere Schnittfuge ermöglicht.

Die stärkste, örtlich begrenzte Erwärmung und die größte Eindringtiefe in metallische Werkstoffe durch deren Verdampfung ermöglicht ein Elektronenstrahl. Deshalb hat auch das Schweißen mit einem Elektronenstrahl besondere Vorzüge, wie geringer Schweißverzug und Energieaufwand. Voraussetzung ist aber die Schweißung in einem evakuierten Raum, da die Luftmoleküle den Elektronenstrahl behindern.

Bereits vor einigen Jahrzehnten, siehe US PS 321538 vom 05.11.1963, wurde auch eine non-vakuum Elektronenstrahltechnologie für das Schweißen entwickelt und einige Jahre später auch in der Praxis eingesetzt. Hierfür besitzt die non-vakuum Elektronenstrahlkanone im Ausgangsbereich des Elektronenstrahls hintereinanderliegende Räume mit stufenweise geringerem Vakuum. Die Austrittsdüse wird dicht über dem Werkstoff geführt, so dass der störende Einfluss der Luftmoleküle ausreichend niedrig bleibt. Zusätzlich wird ein Schutzgas innerhalb und teilweise auch außerhalb der Austrittsdüse zugeführt, der im Bereich in der Düse und über dem Schweißbad die Luft verdrängt.

Ein praxisgerechtes Verfahren für thermische Trennschnitte unter Nutzung eines Elektronenstrahls wurde bisher nicht realisiert, da bekannt war, dass der Elektronenstrahl in der Atmosphäre stark streut. Es wurde auch angenommen, dass der erforderliche Gasstrom zum Ausblasen des geschmolzenen Materials den Elektronenstrahl direkt behindert.

Bei einer Versuchsdurchführung wurde zufällig auch ein Verfahren zum thermischen Bohren von sehr kleinen Löchern in Metall mit einem Elektronenstrahl gefunden. Hierbei wird das Material kurzzeitig kanalförmig erhitzt und ein unter dem Werkstück liegendes spezielles Material verdampft. Der entstandene Gasstrom drängt explosionsartig das geschmolzene Material entgegengesetzt zur Ausbreitung des Elektronenstrahls aus dem Werkstück heraus. Einzelheiten zu diesem Verfahren sind in der DE 3019025 C2, Anmeldetag 19.05.1980 und der US PS 3649806 beschrieben.

Ein praktisch realisierbares Verfahren für thermische Trennschnitte mit einem Elektronenstrahl konnte daraus bisher nicht abgeleitet werden. Auch sehr dicht nebeneinander liegende Bohrungen sind nicht herstellbar, da die vorhanden Bohrung durch die Wärme der neuen Bohrung wieder zugeschmolzen wird.

Über Versuche zum thermischen Trennen mit einem Elektronenstrahl im Vakuum wurde von A. Kaidalow in dem Vortrag "Electron beam cutting of metals" auf einer Tagung vom 24. - 26.Mai 1995 in Timisoara, Rumänien berichtet. Es zeigte sich, dass trotz Absaugung der verdampfenden Partikel im Schnittbereich noch soviel störende Partikel im Vakuumraum vorhanden waren, dass die Funktion der Elektronenstrahlbeschleunigung gestört wurde.

Die WO 2005/011907 A2 beschreibt ein Verfahren und eine Vorrichtung zum Schweißen mit einer non-vacuum Elektronenstrahlkanone unter atmosphärischen Bedingungen. Eine Anwendung zum thermischen Trennen ist nicht Gegenstand der Erfindung. Es wird die zusätzliche Zuführung von Schutzgas 11, 28 durch eine seitliche Schutzgaszuführung offenbart. Das Schutzgas soll den Bereich zwischen der Einrichtung 32 zur Zuführung von Prozessgas 33, bzw. dem Austritt des Elektronenstrahls und dem zu schweißenden Werkstück ausfüllen. Dadurch sollen atmosphärische Störeinflüsse verhindert und die Qualität der Schweißnaht verbessert werden. Ein spezieller Winkel zur Zuführung ist nicht angegeben und nicht erforderlich, da nur der Raum über der Schweißstelle mit Schutzgas angereichert werden soll.

Das gesondert zugeführte Schutzgas 11, 28 erweitert hier nur den Wirkungsbereich des sogenannten Prozessgases 33. Das Prozessgas 33 hat in einer non vacuum Elektronenstrahlkanone die wichtige Funktion, ein Einsaugen von Luft in den Austrittskanal des Elektronenstrahls zu verhindern. Im Austrittskanal wird an mehreren Abschnitten ständig Gas abgesaugt um ein stufenweise steigendes Vakuum bis zum maximalen Vakuum im Raum für die Erzeugung und Beschleunigung des Elektronenstrahls zu sichern. Es hat sich dazu bewährt, im Bereich der Austrittsdüse des Elektronenstrahls quer zu dessen Längsachse ein spezielles Prozessgas (Schutzgas) zuzuführen.

Dieser Bereich wird auch als "gasdynamisches Fenster" bezeichnet und erfordert eine Regelung von Gasdruck und Gasmenge in Abhängigkeit von den aktuellen Parametern des Elektronenstrahls, was sich wiederum auf die Gasabsaugung/das Teilvakuum im Austrittskanal des Elektronenstrahls auswirkt.
Für einen Schneidprozess, in dem Gase in der Schneidfuge verflüssigten Werkstoff, bzw. Schlacke austreiben müssen, ist aus dieser Entgegenhaltung nichts zu entnehmen.

In der US PS 3,175,073 wird eine besondere Ausgestaltung des "gasdynamischen Fensters" beschrieben. Durch eine einseitige Verbreiterung der Austrittsdüse für den Elektronenstrahl soll Prozessgas auch in den Raum zwischen der Austrittsdüse und dem Werkstück geleitet werden. Diese Lösung ist für Schneidverfahren, wie vorhergehend erläutert, nicht einsetzbar und auch für Schweißverfahren ungünstig. Eine eigenständige Regelung für die Schutzgaszuführung in dem Raum über dem Werkstück ist nicht mehr gegeben, bzw. der Gastrom im "gasdynamischen Fenster" ist damit gekoppelt. Als Schneidgasstrahl kann dieser Gasstrom nicht genutzt werden.

Die JP PS 002623484 offenbart eine non vacuum Elektronenstrahlkanone, die auch zum thermischen Trennen (Schneiden) von Werkstücken unter atmosphärischer Umgebung einsetzbar sein soll.

In einer Ausführungsvariante gemäß Fig. 3 wird ein zusätzlicher Schneidgasstrahl 21 (konzentrierter Gasstrahl) mittels einer zusätzlichen Düse 20 etwa parallel, mit einem Abstand zum Elektronenstrahl EB auf das Werkstück gelenkt, um die Schmelze auszublasen. Gleichzeitig wird ein Teil des Prozessgases koaxial zum Elektronenstrahl ausgeblasen. Der Schneidgasstrahl 21 besitzt über die ganze Länge, einschließlich des Bereiches des Auftreffens auf das Werkstück, einen Abstand zum Elektronenstrahl. Hier soll offensichtlich der Schneidgasstrahl 21 nicht den Elektronenstrahl EB im Schmelzbereich berühren.

Außerdem ist die Düse 18 für den Schneidgasstrahl 21 fest angeordnet, also nicht verschwenkbar und nur zusammen mit der non-vacuum Elektronenstrahlkanone höhenverstellbar. Weiterhin ist eine Absaugung unterhalb des Werkstückes nicht vorgesehen.
Diese Konzeption konnte bisher nicht gewerblich, praktisch realisiert werden, weil sie nicht variabel einsatzfähig ist und keine ausreichende Leistung und Schnittqualität besitzt.

In der DE 38 01 068 A1 wird ein Verfahren zum Abtragen von Werkstückmaterialien aus dem Vollen mit einem Energiestrahl wie Laser-, oder Elektronenstrahl aufgezeigt. Das Material soll also nicht wie beim bekannten Brennschneiden durch eine Schnittfuge nach unten abgeführt, sondern seitlich entfernt werden. Als Lösung wird ein zusätzlicher Fluidstrahl zum Kühlen des verflüssigten Materials verwendet. Dieser Fluidstrahl soll gleichzeitig die erstarrten Partikel seitlich abführen. Deshalb erfolgt die Zuführung unter einem Winkel zur Werkstückoberfläche und zur Achse des Energiestrahls. Als Fluid wird eine Flüssigkeit, bevorzugt Wasser, eingesetzt. Über einen Anschluss 7 wird einer Düse, in der der Energiestrahl geführt ist, wie üblich ein Arbeitsgas zum oxydieren zugeführt. Das Arbeitsgas umhüllt somit den Energiestrahl.

Eine Nutzung dieses Verfahrens und der Vorrichtung mit einem Elektronenstrahl als Energiestrahl ist aus mehreren Gründen unmöglich. Der verwendete Spiegel 4 würde vom Elektronenstrahl zerstört. Der Weg des Elektronenstrahls in der Atmosphäre durch die Führungsrohre 2 und 3 und Düse 6 ist so lang, dass dieser zerstreut und wirkungslos wird. Weiterhin zerstreut das über den Anschluss 7 zugeführte Arbeitsgas den Elektronenstrahl. Ein Fluidstrahl würde auch die Schmelze zu sehr abkühlen, da ein Elektronenstrahl (als Vorteil) seine Energie auf eine sehr kleine Fläche konzentriert. In der erteilten DE 38 01 068 C2 sind deshalb auch keine Angaben mehr über den Einsatz eines Elektronenstrahls enthalten.

Beim thermischen Schneiden entstehen gesundheitsschädliche Abgase, Schlacken und Stäube. Diese beeinträchtigen die Gesundheit des Bedienpersonals und die technischen Geräte.
Es ist seit längerem bekannt, die Abgase und Stäube oberhalb der Schneidvorrichtung abzusaugen (DE 2634076 A). Nachteilig ist hierbei, dass viel Umgebungsluft mit abgesaugt wird und andererseits die unterhalb des Werkstückes geblasenen Abgase und Schlacketeilchen nur unzureichend abgesaugt werden.

Es sind deshalb schon Vorschläge entwickelt worden, die Absaugung unterhalb des Werkstückes durchzuführen. Gemäß der DE 3531192 A1 ist unter dem Werkstückträger ein verfahrbarer Absaugtrichter angeordnet, der sich über die gesamte Breite des Werkstückträgers erstreckt. Dieser wird mit der Längsbewegung des Schneidbrenners mitgeführt. In der DE 9103105 U1 wird vorgeschlagen, mehrere abgegrenzte Absaugfelder unterhalb des Werkstückträgers einzurichten. Es wird immer nur in dem Feld abgesaugt, über dem sich der Schneidbrenner befindet. Gemäß der DE 102007037786 A1 wird unterhalb des Werkstückes, im Bereich der Schnittzone zusätzlich zum Saugkasten ein Schiebeschild für Schnittabfälle mit dem Schneidbrenner mitgeführt.

Bei diesen und anderen Lösungen besteht immer ein Spalt zwischen dem Absaugtrichter (auch Saugkasten, Saugwagen genannt) und dem Werkstückträger bzw. dem Werkstück, durch den die Umgebungsluft mit angesaugt wird. Das erfordert eine große Absaugleistung. Andererseits ist der Einfluss der Absaugung auf den eigentlichen Schneidprozess nicht Gegenstand dieser Erfindungen.

### Aufgabe der Erfindung

Aufgabe der Erfindung ist es, thermische Schneidverfahren und Vorrichtungen zu schaffen, dass eine hohe Energieeffizienz besitzt und eine große Materialvielfalt bearbeiten kann, in dem ein Energiestrahl mit hoher Energiedichte und Eindringtiefe eingesetzt wird, der eine konzentrierte und damit verbundene geringe Wärmeeinbringung ermöglicht. Eine weitere Aufgabe ist es, den Einsatz eines Schneidverfahrens mit einem Elektronenstrahl einer non-vacuum Elektronenstrahlkanone (NVEB) unter Atmosphärendruck zu ermöglichen. Eine weitere Aufgabe besteht darin, beim Schmelzschneiden mit einem Elektronenstrahl unter Atmosphärendruck, die Strömung des Austreibgases so zu beeinflussen, dass der Elektronenstrahl durch dieses nicht negativ beeinflusst und andererseits die Ausbringung der Schmelze und/oder Schlacke aus der Schneidfuge verbessert wird.

Erfindungsgemäß wird die Aufgabe entsprechend den Merkmalen der Ansprüche 1, 2, 4, 5 und 6 gelöst. Gemäß Anspruch 1 wird ein Elektronenstrahl (1) mit einem prozessabhängigen Abstand der Austrittsdüse (3) für den Elektronenstrahl (1) zum Werkstoff (4) von 0,3 mm bis 50 mm, bevorzugt von unter 10 mm und unter einem Winkel von 15° bis 90° zur Werkstoffoberfläche auf den Werkstoff (4) gerichtet. Gleichzeitig wird ein konzentrierter Gasstrahl (5) mit hoher Strömungsgeschwindigkeit auf die durch den Elektronenstrahl (1) erzeugte Schmelz- bis Verdampfungsphase (6) unter einem Winkel kleiner 90° zum Elektronenstrahl (1) und zum Werkstoff (4) geblasen, so dass der Elektronenstrahl (1) und der Gasstrahl (5) erst im Bereich der Schmelz- bis Verdampfungsphase (6) den geringsten Abstand besitzen. Darüber vergrößert sich der Abstand zwischen der Austrittsdüse 3 und Druckgasdüse 8.
Mit dem Elektronenstrahl (1) wird der Werkstoff (4) nur im Oberflächenbereich des Werkstoffes (4) wenigstens auf Zündtemperatur gebracht. Der Gasstrahl (5) ist nachlaufend zum Elektronenstrahl (1) gerichtet und aus Sauerstoff oder aus einem Gemisch aus Sauerstoff und einem brennbaren Gas wie Wasserstoff, Propan, Butan. Durch ein Oxydieren des Werkstoffes (4) und dem Verbrennungsprozess wird weitere Wärme erzeugt und ein Durchtrennen der gesamten Werkstoffdicke durch Ausblasen der Oxyde bewirkt.

Durch Versuche wurde überraschend gefunden, das der aus der non-vacuum Elektronenstrahlkanone austretende Elektronenstrahl in dem kurzen Weg durch die Atmosphäre bekanntermaßen etwas gestreut wird, aber im Bereich des Materials, insbesondere im durch Erhitzung erzeugten Bereich nicht weiter gedämpft, bzw. gestreut wird. Vielmehr entsteht ein schmaler, sich nicht verbreiternder Kanal im Werkstoff, annähernd entsprechend dem Durchmesser des Elektronenstrahls.
Nach dem derzeitigen Erkenntnisstand wird durch die Verdampfung und dem damit verbundenen Gasdruck ein Bereich mit einer stark verringerten Atom- bzw. Moleküldichte erzeugt. In diesem führt sich der Elektronenstrahl gradlinig selbst weiter in das Material.

Weiterhin wurde gefunden, dass auch ein in diesem Bereich zugeführter Gasstrahl den Elektronenstrahl nicht nennenswert dämpft. Vielmehr wird die bekannte Funktion eines Gasstrahles beim thermischen Trennen auch hier wirksam, nämlich Schlacke, geschmolzene und verdampfte Materialpartikel auszublasen, bzw. das Material zu oxydieren.
Das Verfahren löst damit überraschend einfach das Problem, ein thermisches Schneidverfahren mit Elektronenstrahl unter atmosphärischen Bedingungen zu realisieren und sogar mit einem Gasstrahl für das Ausblasen des oxydierten/verflüssigten/ verdampften Materials zu kombinieren. Die bisher bekannte Ansicht, dass mit einem Elektronenstrahl kein effektives thermisches Trennen unter atmosphärischen Bedingungen möglich ist, wurde hierdurch widerlegt.

Damit können alle bekannten Vorteile eines Elektronenstrahls beim Schweißen auch beim thermischen Trennen genutzt werden.
Die erforderliche Energie für die Erzeugung der Schneidfuge kann verringert, der Materialverlust durch die Schnittfuge vermindert und die Verschmutzung durch die ausgeworfene Schlacke abgesenkt werden. Weiterhin wird durch den verringerten Energieeintrag der Verzug im Werkstoff gesenkt.
Das Verfahren besitzt auch den Vorteil, für viele Werkstoffarten einsetzbar zu sein. Dies Variante nach Anspruch 1 nutzt den bekannten Effekt eines oxydierenden Gasstrahles beim thermischen Trennverfahren. Durch die thermischen Reaktionen wird zusätzlich Wärme erzeugt und der Schneidprozess beschleunigt.

Gemäß einer vorteilhaften Verfahrensvariante mit anderen Gasstrahlen und thermischen Wirkungen nach Anspruch 2 wird ein Elektronenstrahl (1) mit einem prozessabhängigen Abstand der Austrittsdüse (3) für den Elektronenstrahl (1) zum Werkstoff (4) von 0,3 mm bis 50 mm, bevorzugt von unter 10 mm und unter einem Winkel von 15° bis 90° zur Werkstoffoberfläche auf den Werkstoff (4) gerichtet. Gleichzeitig wird ein konzentrierter Gasstrahl (5) mit hoher Strömungsgeschwindigkeit auf die durch den Elektronenstrahl (1) erzeugte Schmelz- bis Verdampfungsphase (6) unter einem Winkel kleiner 90° zum Elektronenstrahl (1) und zum Werkstoff (4) geblasen, so dass der Elektronenstrahl (1) und der Gasstrahl (5) erst im Bereich der Schmelz- bis Verdampfungsphase (6) den geringsten Abstand besitzen. Darüber vergrößert sich der Abstand zwischen der Austrittsdüse 3 und Druckgasdüse 8.
Mit dem Elektronenstrahl (1) wird örtlich fokussiert der Werkstoff (4) in der gesamten Werkstoffdicke zum Schmelzen und Verdampfen gebracht.
Der Gasstrahl (5) besteht aus einem inerten Gas wie Argon, Kohlendioxyd, Stickstoff oder einer Mischung inerter Gase, der über die gesamte Tiefe des geschmolzenen bis verdampften Werkstoffes (4) geführt wird und die flüssige und gasförmige Phase ausbläst.

In dieser Verfahrensvariante wird die gesamte Wärme durch den Elektronenstrahl (1) erzeugt. Es wird weniger Werkstoff (4) oxydiert, wodurch weniger Schlacke (7) anfällt. Dieses Verfahren ist besonders für geringere Materialstärken geeignet.

Gemäß dem Unteranspruch 3 wird mindestens im Bereich der Schmelzphase des Werkstückes (4), bzw. des Elektronenstrahls (1) im Werkstoffbereich ein Druckunterschied von 50 mbar bis 800 mbar zwischen oberer und unterer Werkstückoberfläche erzeugt. Damit wird ein Ansaugen des Gasstrahls (5), der Schmelz- bis Verdampfungsphase (6) des Werkstückes (4), sowie Schlacke (7) aus dem Schneidspalt nach unterhalb des Werkstückes (4) bewirkt.

Je nach Werkstückdicke und Unterdruckgröße wird weniger oder kein teueres Austreibgas benötigt. Die Absaugströmung in der Schneidfuge hat eine Austreibwirkung auf die Schmelze und/oder Schlacke in der Schnittfuge.
Die Gasverwirbelungen um den Elektronenstrahl werden außerdem vermindert und dadurch die Elektronen weniger abgebremst, bzw. gestreut. Das bewirkt eine gleichmäßigere Verteilung der Elektronenstrahlleistung und damit eine Verbesserung der Qualität der Schnittoberfläche des Werkstückes.

Zur Durchführung des Verfahrens nach Anspruch 3 sind gemäß der Erfindung drei verschiedene Vorrichtungen in den Ansprüchen 4 bis 6 beansprucht. Diese enthalten optimale Varianten zur Erzeugung eines Druckunterschiedes von 50 mbar bis 800 mbar zwischen oberer und unterer Werkstückoberfläche. Es werden neue Lösungen zur Abdichtung zwischen dem Absaugtrichter und der unteren Fläche des Werkstückes, bzw. Werkstückträgers aufgezeigt, um mit geringer Energie einen Unterdruck in diesem Bereich zu erzeugen.

### Beispiele

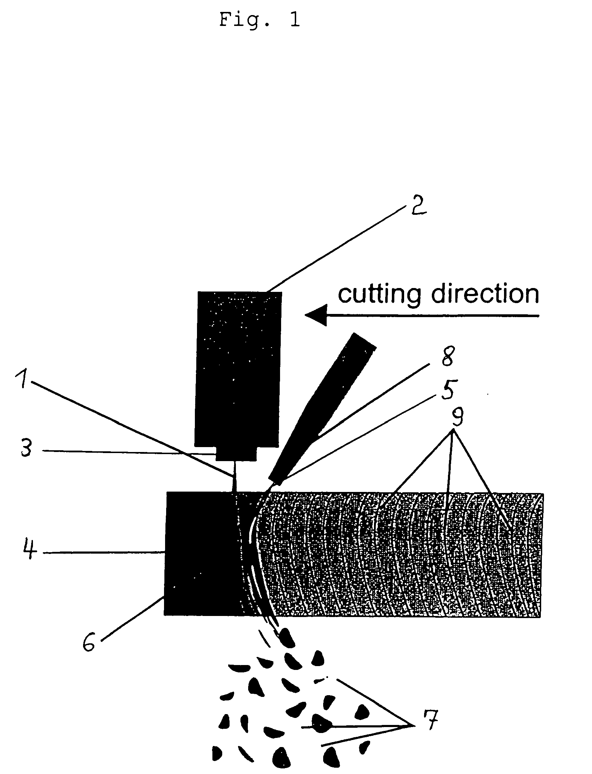

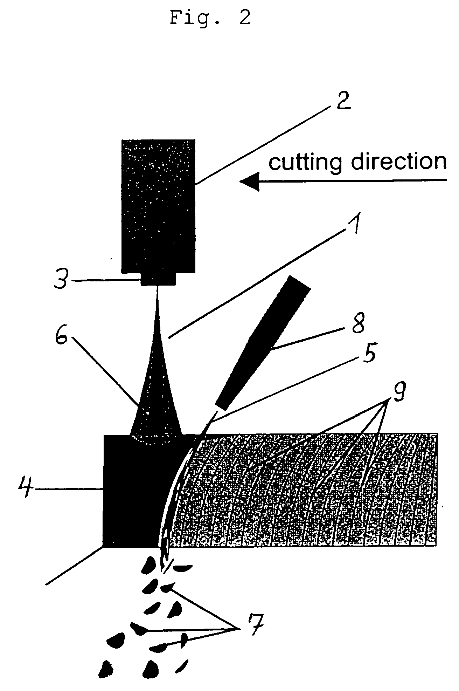

Nachfolgend sollen das Verfahren und die Absaugvorrichtung an je zwei Beispielen erläutert werden. Die Fig. 1 zeigt das Prinzip des Schneidverfahrens mit einem Schutzgas, die Fig. 2 zeigt das Prinzip des Schneidverfahrens mit einem oxydierendem Gas.

### Beispiel 1

Eine Vorrichtung zur Ausführung eines Verfahrens zum Schmelzschneiden von Stahl mit einem Elektronenstrahl 1 und Gasstrahl 5 aus inertem Gas ist im Prinzip in der Figur 1 dargestellt.
Zum Einsatz kommt eine non-vacuum Elektronenstrahlkanone 2 (NVEB) des Herstellers PTR Präzisionstechnik GmbH. Diese ist an einer nicht dargestellten Führungs- und Vorschubeinrichtung befestigt. Die Befestigung ermöglicht eine Höhenverstellung, wodurch der Abstand der Düsenmündung der Austrittsdüse 3 des Elektronenstrahls 1 von der Oberfläche des Werkstoffes 4, bzw. Werkstückes einreguliert werden kann. Durch die Abstandsänderung wird die Streuung des Elektronenstrahls 1, die durch die Atmosphäre bewirkt wird, verändert. Die Befestigung ermöglicht weiterhin ein Schwenken orthogonal zur Elektronenstrahlachse.

An der Führungs- und Vorschubeinrichtung ist weiterhin eine Druckgasdüse 8 horizontal und vertikal verstellbar befestigt. Nicht dargestellt ist die Verbindung über eine Druckleitung zur regelbaren Druckgaseinrichtung.
Zum Schmelzschneiden von z. B. rostfreiem Stahl Typ 1.4301 von 3 mm Dicke wird die NVEB 2 vertikal zur Vorschubrichtung geschwenkt, so dass der Elektronenstrahl 1 mit dem Werkstück 4 einen Winkel von 72° einschließt. Der Abstand zur Austrittsdüse 3 zur Werkstückoberfläche beträgt 7 mm, gemessen entlang der Strahlachse.

Die Gasdüse 8 wird entgegengesetzt der Vorschubrichtung verschwenkt, so dass diese mit dem Werkstück 4 einen Winkel von 60° einschließt. Der Abstand zum Werkstück 4 beträgt 3 mm, gemessen entlang der Strahlachse. Der Abstand der Mittelachsen beider Düsen 3, 8 in Höhe der Düsenmündungen beträgt ca. 10 mm.

Als Druckgas wird Argon mit einem Druck p = 10 bar eingesetzt. Bei einer Leistung im Elektronenstrahl 1 von P = 21 kW konnte eine Schneidgeschwindigkeit von v = 10 m/min erzielt werden, wobei der Elektronenstrahl 1 die gesamte Dicke des Werkstückes 4 durchdringt. Die Schneidriefenausbildung am Werkstoff 4 in der Schnittfuge ist besonders von der Schnittgeschwindigkeit abhängig. Die Werkstoffoberfläche in diesem Bereich ist nur minimal mit Schlacke 7 belastet.

### Beispiel 2

Die Vorrichtung zur Ausführung eines Verfahrens zum Brennschneiden von Stahl mit einem Elektronenstrahl 1 und einem oxydierenden Gasstrahl 5 ist mit der vorher beschriebenen identisch. Als Gas wird Sauerstoff verwendet. Das Verfahren ist dahingehend variiert, dass nur die Oberfläche des Werkstückes 4 im Schnittbereich durch den Elektronenstrahl 1 erhitzt wird. Die Leistung des Elektronenstrahls 1, die Schnittgeschwindigkeit und der Abstand der Austrittsdüse 3 ist dazu so eingestellt, dass in diesem Bereich die Zündtemperatur zur Oxydierung des Stahls durch den Sauerstoffstrahl gesichert wird. Die Schnittfuge selbst wird durch den Gasstrahl 5 erzeugt.

Für das Brennschneiden von z. B. Baustahl Typ St 37 von 20 mm Dicke wurden folgende Winkel und Abstände eingestellt: Winkel zwischen Elektronenstrahl 1 und Werkstück 4 85°, Winkel der Druckgasdüse 8 zum Werkstück 4 60°, Abstand der Austrittsdüse 3 zum Werkstück 4 30 mm, Abstand der Gasdüse 8 zum Werkstück 4 5 mm. Bei einem Gasdruck von p= 12 bar und einer Leistung des Elektronenstrahls 1 von P = 2,8 kV wurde eine Schnittgeschwindigkeit von v = 0,6 m/min erreicht.

### Beispiele zur Absaugvorrichtung

Beide Vorrichtungen bestehen aus einem an sich bekannten Absaugtrichter, der mit einer Absaugung verbunden ist. Der Absaugtrichter ist unterhalb des Bereiches der Schmelzphase des Werkstückes 4 angeordnet. Die Oberkante des Absaug-trichters ist mittels Dichtelementen annähernd luftdicht mit der Werkstückunterfläche oder dem Werkstückträger verbunden. Diese Abdichtung muss auch während der Vorschubbewegung des Brennschnittes gesichert sein. Mit einer relativ geringen Saugleistung kann somit ein Unterdruck in diesem Bereich erzeugt werden.

Beispiel 1 zur Absaugvorrichtung
In einer Variante für kleine Werkstücke 1 erstreckt sich der Absaugtrichter über die gesamte Fläche des Werkstückes 1 und ist mit diesem unverschiebbar über eine elastische, warmfeste Dichtleiste verbunden. Die NVEB 2 ist stationär angeordnet und die Vorschubbewegung des Brennschnittes erfolgt durch die Bewegung des Werkstückträgers zusammen mit der Absaugung.

Beispiel 2 zur Absaugvorrichtung In einer Variante für größere Werkstücke 4 ist die NVEB 2 mit dem Absaugtrichter in einer horizontalen Ebene und das Werkstück 4 in einer zweiten horizontalen Ebene bewegbar angeordnet. Der Absaugtrichter verfährt somit nur gradlinig, parallel mit der Bewegung der Elektronenstrahlkanone 2. Das ermöglicht eine Abdichtung des Bewegungsspaltes durch zwei sich überlappende, elastische Dichtungsstreifen. Im Bereich unterhalb der Schmelzphase durchdringt der Absaugtrichter die Dichtungsstreifen, in dem diese auseinander gedrückt werden und das Oberteil des Absaugtrichters elastisch umschließen.

Verzeichnis der Bezugszeichen
- 1: Elektronenstrahl
- 2: non-vacuum Elektronenstrahlkanone (NVEB)
- 3: Austrittsdüse
- 4: Werkstoff, Werkstück
- 5: Gasstrahl
- 6: Schmelz- und Verdampfungsphase
- 7: Schlacke, entfernte geschmolzene Werkstoffteilchen
- 8: Druckgasdüse
- 9: Schneidriefen

## Patentansprüche

1. Verfahren zum thermischen Trennen von Werkstoffen mit einem Elektronenstrahl aus einer non-vacuum Elektronenstrahlkanone bei einer Umgebung mit Atmosphärendruck in dem diese mit einem Elektronenstrahl örtlich fokussiert zum Schmelzen bis Verdampfen gebracht und diese Phasen aus dem Werkstoff ausgetrieben werden, **dadurch gekennzeichnet,**
**dass** ein Elektronenstrahl (1) mit einem prozessabhängigen Abstand der Austrittsdüse (3) für den Elektronenstrahl (1) zum Werkstoff (4) von 0,3 mm bis 50 mm, bevorzugt von unter 10 mm und unter einem Winkel von 45° bis 90° zur Werkstoffoberfläche auf den Werkstoff (4) gerichtet wird
und gleichzeitig ein konzentrierter Gasstrahl (5) mit hoher Strömungsgeschwindigkeit auf die durch den Elektronenstrahl (1) erzeugte Schmelz- bis Verdampfungsphase (6) um ca. 30° nachlaufend zum Elektronenstrahl (1) geblasen wird, so dass der Elektronenstrahl (1) und der Gasstrahl (5) erst im Bereich der Schmelz- bis Verdampfungsphase (6) den geringsten Abstand besitzen, und sich darüber der Abstand zwischen der Austrittsdüse (3) und Druckgasdüse (8) vergrößert,
wobei mit dem Elektronenstrahl (1) der Werkstoff (4) nur im Oberflächenbereich des Werkstoffes (4) wenigstens auf Zündtemperatur gebracht wird, der Gasstrahl (5) aus Sauerstoff oder aus einem Gemisch aus Sauerstoff und einem brennbaren Gas wie Wasserstoff, Propan, Butan besteht,
so das durch ein Oxydieren des Werkstoffes (4) und dem Verbrennungsprozess weitere Wärme erzeugt und ein Durchtrennen der gesamten Werkstoffdicke durch Ausblasen der Oxyde bewirkt wird.

2. Verfahren zum thermischen Trennen von Werkstoffen mit einem Elektronenstrahl aus einer non-vacuum Elektronenstrahlkanone bei einer Umgebung mit Atmosphärendruck in dem diese mit einem Elektronenstrahl örtlich fokussiert zum Schmelzen bis Verdampfen gebracht und diese Phasen aus dem Werkstoff ausgetrieben werden, **dadurch gekennzeichnet,**
**dass** ein Elektronenstrahl (1) mit einem prozessabhängigen Abstand der Austrittsdüse (3) für den Elektronenstrahl (1) zum Werkstoff (4) von 0,3 mm bis 50 mm, bevorzugt von unter 10 mm und unter einem Winkel von 15° bis 90° zur Werkstoffoberfläche auf den Werkstoff (4) gerichtet wird
und gleichzeitig ein konzentrierter Gasstrahl (5) mit hoher Strömungsgeschwindigkeit auf die durch den Elektronenstrahl (1) erzeugte Schmelz- bis Verdampfungsphase (6) unter einem Winkel kleiner 90° zum Elektronenstrahl (1) und zum Werkstoff (4) geblasen wird, so dass der Elektronenstrahl (1) und der Gasstrahl (5) erst im Bereich der Schmelz- bis Verdampfungsphase (6) den geringsten Abstand besitzen und sich darüber der Abstand zwischen der Austrittsdüse (3) und Druckgasdüse (8) vergrößert,
wobei mit dem Elektronenstrahl (1) örtlich fokussiert der Werkstoff (4) in der gesamten Werkstoffdicke zum Schmelzen und Verdampfen gebracht wird,
der Gasstrahl (5) aus einem inerten Gas oder einer Mischung inerter Gase besteht, der über die gesamte Tiefe des geschmolzenen bis verdampften Werkstoffes (4) geführt wird und die flüssige und gasförmige Phase ausbläst.

3. Verfahren nach einen der Ansprüche 1 oder 2, **dadurch gekennzeichnet,**
**dass** mindestens im Bereich der Schmelzphase des Werkstückes (4), bzw. des Elektronenstrahls (1) im Werkstoffbereich ein Druckunterschied von 50 mbar bis 800 mbar zwischen oberer und unterer Werkstückoberfläche erzeugt wird, um ein Ansaugen des Gasstrahls (5), der Schmelz- bis Verdampfungsphase (6) des Werkstückes (4), sowie Schlacke (7) aus dem Schneidspalt nach unterhalb des Werkstückes (4) zu bewirken.

4. Vorrichtung zur Durchführung des Verfahrens nach Anspruch 3, bestehend aus einer Antriebs-, Führungs- und Energieversorgungseinheit für einen Wärmeenergie- und Gasstrahlerzeuger, sowie Werkstückträger mit Absaugtrichter,
an einer non-vacuum Elektronenstrahlkanone (2) eine Druckgasdüse (8), die mit einer Druckgaseinrichtung verbunden ist, im Bereich der Austrittsdüse (3) des Elektronenstrahls verstellbar befestigt ist,
wobei die Achse der Austrittsdüse (3) und die Achse der Druckgasdüse (8) einen Winkel von 0° bis 90° einschließen und die Achse der Austrittsdüse (3) einen Winkel von 15° bis 90° zur Werkstoffoberfläche einschließt, **dadurch gekennzeichnet, dass** die Mündungen der Austrittsdüse und Druckgasdüse (3, 8) gegeneinander versetzt sind, einen Abstand unter 10 mm besitzen und deren Abstände zur Werkstückoberfläche in einem Bereich von 0,3 mm bis 50 mm höhenverstellbar sind
und dass für kleine Werkstücke (4) sich ein Absaugtrichter über die gesamte untere Fläche des Werkstückes (4) oder Werkstückträgers erstreckt und mit diesem unverschiebbar über eine elastische, warmfeste Dichtleiste verbunden ist, die non-vacuum Elektronenstrahlkanone (2) stationär angeordnet ist und die Vorschubbewegung durch die Bewegung des Werkstückes (4) oder des Werkstückträgers zusammen mit dem der Absaugung mittels einem zweiachsigen Antrieb erfolgt.

5. Vorrichtung zur Durchführung des Verfahrens nach Anspruch 3, bestehend aus einer Antriebs-, Führungs- und Energieversorgungseinheit für einen Wärmeenergie- und Gasstrahlerzeuger, sowie Werkstückträger mit Absaugtrichter, an einer non-vacuum Elektronenstrahlkanone (2) eine Druckgasdüse (8), die mit einer Druckgaseinrichtung verbunden ist, im Bereich der Austrittsdüse (3) des Elektronenstrahls verstellbar befestigt ist,
wobei die Achse der Austrittsdüse (3) und die Achse der Druckgasdüse (8) einen Winkel von 0° bis 90° einschließen und die Achse der Austrittsdüse (3) einen Winkel von 15° bis 90° zur Werkstoff Oberfläche einschließt, **dadurch gekennzeichnet, dass** die Mündungen der Austrittsdüse und Druckgasdüse (3, 8) gegeneinander versetzt sind, einen Abstand unter 10 mm besitzen und deren Abstände zur Werkstückoberfläche in einem Bereich von 0,3 mm bis 50 mm höhenverstellbar sind
und dass für größere Werkstücke (4) der Absaugtrichter mit der Schnittbewegung der non-vacuum Elektronenstrahlkanone (2) mittels einer Verbindung zu dieser oder einem gesteuerten Antrieb mitgeführt wird und eine Abdichtung des Bewegungsspaltes zwischen der Oberkante des Absaugtrichters und dem Werkstückträger durch mehrere nebeneinanderliegende elastische Borstenreihen am Ansaugtrichter erfolgt.

6. Vorrichtung zur Durchführung des Verfahrens nach Anspruch 3, bestehend aus einer Antriebs-, Führungs- und Energieversorgungseinheit für einen Wärmeenergie- und Gasstrahlerzeuger, sowie Werkstückträger mit Absaugtrichter, an einer non-vacuum Elektronenstrahlkanone (2) eine Druckgasdüse (8), die mit einer Druckgaseinrichtung verbunden ist, im Bereich der Austrittsdüse (3) des Elektronenstrahls verstellbar befestigt ist,
wobei die Achse der Austrittsdüse (3) und die Achse der Druckgasdüse (8) einen Winkel von 0° bis 90° einschließen und die Achse der Austrittsdüse (3) einen Winkel von 15° bis 90° zur Werkstoffoberfläche einschließt, **dadurch gekennzeichnet, dass** die Mündungen der Austrittsdüse und Druckgasdüse (3, 8) gegeneinander versetzt sind, einen Abstand unter 10 mm besitzen und deren Abstände zur Werkstückoberfläche in einem Bereich von 0,3 mm bis 50 mm höhenverstellbar sind
und dass für größere Werkstücke die non-vacuum Elektronenstrahlkanone (2) mit dem Absaugtrichter in einer horizontalen Achse und das Werkstück (4) oder der Werkstückträger in einer zweiten horizontalen Achse, rechtwinklig zur ersten, mittels entsprechender Antriebe verfahrbar sind,
die Abdichtung des geraden Bewegungsspaltes für den Absaugtrichter durch zwei sich überlappende, elastische Dichtungsstreifen unterhalb des Werkstückes (4) oder Werkstückträgers erfolgt und der obere Teil des Absaugtrichters zwischen diesen angeordnet ist, so das die Dichtungsstreifen den Absaugtrichter dichtend umschließen und die Schnittbewegung durch die Überlagerung der beiden horizontalen Bewegungen mittels einer Steuerung erfolgt.

## Claims

1. A method for thermal cutting of materials with an electron beam from a non-vacuum electron beam gun in an environment with atmospheric pressure in which these are melted and evaporated with a locally focused electron beam and these phases are expelled from the material,
**characterized in that**,
an electron beam (1) is directed with a process-dependent distance of the outlet nozzle (3) for the electron beam (1) to the material (4) of 0.3 mm - 50 mm, preferably less than 10 mm and under an angle of 45° - 90° to the material surface on the material (4) and simultaneously a concentrated gas beam (5) with high current speed is blown onto the melting and evaporation phase (6) generated by the electron beam (1) at approximately 30° behind the electron beam (1), so that the electron beam (1) and the gas beam (5) have the lowest distance at first in the area of the melting and evaporation phase, and above this the distance between the outlet nozzle (3) und pressurized gas nozzle (8) increases,
wherein with the electron beam (1) the material (4) is brought only in the surface area of the material (4) to at least ignition temperature, and the gas beam (5) comprises oxygen or a mixture of oxygen and a combustible gas such as hydrogen, propane or butane,
so that through oxidization of the material (4) and the combustion process further heat is produced and causes a separation of the total material thickness by blowing out of the oxides.

2. A method for thermal cutting of materials with an electron beam from a non-vacuum electron beam gun in an environment with atmospheric pressure in which these are melted and evaporated with a locally focused electron beam and these phases are expelled from the material,
**characterized in that**,
an electron beam (1) is directed with a process-dependent distance of the outlet nozzle (3) for the electron beam (1) to the material (4) of 0.3 mm - 50 mm, preferably less than 10 mm and under an angle of 15° - 90° to the material surface on the material(4) and simultaneously a concentrated gas beam (5) with high current speed is blown onto the melting and evaporation phase (6) generated by the electron beam (1) at an angle of less than 90° to the electron beam (1) and to the material (4), so that the electron beam (1) and the gas beam (5) have the lowest distance only in the area of the melting and evaporation phase (6), and across this the distance between the outlet nozzle (3) and pressurized gas nozzle (8) increases,
wherein with the electron beam (1) locally focused the material (4) is brought to melting and evaporation through the full thickness of the material (4), and the gas beam (5) comprises an inert gas or a mixture of inert gases, which is guided over the total depth of the melted and vaporized material (4) and blows out the liquid and gaseous phase.

3. The method according to one of claims 1 or 2, **characterized in that**,
at least in the area of the molten phase of the workpiece (4), or the electron beam (1) in the material area a pressure difference of 50 mbar - 800 mbar is produced between upper and lower workpiece surface, in order to cause suction of the gas beam (5), the melting and evaporation phase (6) of the workpiece (4), and slag (7) from the cutting gap below the workpiece (4).

4. A device for carrying out the method according to claim 3, comprising a drive, guidance and energy supply unit for a thermal energy and gas beam generator, and workpiece carriers with suction funnels, wherein a pressurized gas nozzle (8), connected to a pressurized gas unit, is adjustably secured to a non-vacuum electron beam gun (2) in the area of the outlet nozzle (3) of the electron beam,
wherein the axis of the outlet nozzle (3) and the axis of the pressurized gas nozzle (8) enclose an angle of 0° - 90° and the axis of the outlet nozzle (3) encloses an angle of 15° - 90° to the workpiece surface, **characterized in that**,
the openings of the outlet nozzle und pressurized gas nozzle (3, 8) are offset in relation to each other, and have a distance of less than 10 mm, and their distances to the workpiece surface are height-adjustable in a range of 0.3 mm - 50 mm
and **in that** for small workpieces (4) a suction funnel extends across the entire lower surface of the workpiece (4) or workpiece carrier and is connected with this so that it cannot displace via a flexible, heat-resistant sealing strip, the non-vacuum electron beam gun (2) has a stationary arrangement and the feed movement takes place by the movement of the workpiece (4) or the workpiece carrier together with the suction by means of a dual axis drive.

5. A device for carrying out the method according to claim 3, comprising a drive, guidance and energy supply unit for a thermal energy and gas beam generator, and workpiece carriers with suction funnels, wherein a pressurized gas nozzle (8), connected to a pressurized gas unit, is adjustably secured to a non-vacuum electron beam gun (2) in the area of the outlet nozzle (3) of the electron beam,
wherein the axis of the outlet nozzle (3) and the axis of the pressurized gas nozzle (8) enclose an angle of 0° - 90° and the axis of the outlet nozzle (3) encloses an angle of 15° - 90° to the material surface, **characterized in that**
the openings of the outlet nozzle and pressurized gas nozzle (3, 8) are offset in relation to each other, and have a distance of less than 10 mm, and their distances to the workpiece surface are height-adjustable in a range of 0.3 mm - 50 mm,
and **in that** for larger workpieces (4) the suction funnel is carried along with the cutting movement of the non-vacuum electron beam gun (2) by means of a connection to this or a controlled drive and a sealing of the movement gap between the top edge of the suction funnel and the workpiece carrier takes place by a plurality of adjacent flexible rows of bristles on the suction funnel.

6. A device for carrying out the method according to claim 3, comprising a drive, guidance and energy supply unit for a thermal energy and gas beam generator, and workpiece carriers with suction funnels, wherein a pressurized gas nozzle (8), connected to a pressurized gas unit, is adjustably secured to a non-vacuum electron beam gun (2) in the area of the outlet nozzle (3) of the electron beam,
wherein the axis of the outlet nozzle (3) and the axis of the pressurized gas nozzle (8) enclose an angle of 0° - 90° and the axis of the outlet nozzle (3) encloses an angle of 15° - 90° to the material surface, **characterized in that**,
the openings of the outlet nozzle and pressurized gas nozzle (3, 8) are offset in relation to each other, and have a distance of less than 10 mm, and their distances to the workpiece surface are height-adjustable in a range of 0.3 mm - 50 mm,
and **in that** for larger workpieces the non-vacuum electron beam gun (2) and the suction funnel are moveable in a horizontal axis and the workpiece (4) or the workpiece carrier in a second horizontal axis, at right-angles to the first, by means of suitable drives,
the sealing of the linear movement gap for the suction funnel is achieved by two overlapping, flexible sealing strips below the workpiece (4) or workpiece carrier and the upper part of the suction funnel is arranged between these, so that the sealing strips provide an all-round seal for the suction funnels and the cutting movement takes place by the superimposition of the two horizontal movements by means of a controller.

## Revendications

1. Procédé pour la séparation thermique de matériaux avec un faisceau d'électrons provenant d'un canon à électrons hors vide dans un environnement avec une pression atmosphérique dans laquelle ces matériaux sont portés à la fusion jusqu'à l'évaporation de façon concentrée localement avec un faisceau d'électrons et ces phases sont expulsées hors du matériau, **caractérisé en ce qu'** un faisceau d'électrons (1) est dirigé sur le matériau (4) avec une distance entre la buse de sortie (3) pour le faisceau d'électrons (1) et le matériau (4), en fonction du procédé, de 0,3 mm à 50 mm, de préférence inférieure à 10 mm, et avec un angle de 45° bis 90° avec la surface du matériau (4)
et simultanément, un jet de gaz (5) concentré avec vitesse de flux élevée est soufflé sur la phase de fusion à la phase d'évaporation (6) produite par le faisceau d'électrons (1), avec retard d'env. 30° par rapport au faisceau d'électrons (1), de telle sorte que le faisceau d'électrons (1) et le jet de gaz (5) possèdent la distance la plus faible d'abord dans la zone de la phase de fusion à la phase d'évaporation (6), et **en ce que**, au-dessus, la distance croît entre la buse de sortie (3) et la bus de gaz de pression (8),
avec le faisceau d'électrons, le matériau (4) étant amené uniquement dans la zone de surface du matériau (4) au moins à la température d'inflammation, le jet de gaz (5) se composant d'oxygène ou d'un mélange d'oxygène et d'un gaz combustible tel que l'hydrogène, le propane, le butane,
de telle sorte que, par une oxydation du matériau (4) et par le processus de combustion, une chaleur supplémentaire est produite et une séparation de la totalité de l'épaisseur de matériau est entraînée par le soufflage des oxydes.

2. Procédé pour la séparation thermique de matériaux avec un faisceau d'électrons provenant d'un canon à électrons hors vide dans un environnement avec une pression atmosphérique dans laquelle ces matériaux sont portés à la fusion jusqu'à l'évaporation de façon concentrée localement avec un faisceau d'électrons et ces phases sont expulsées hors du matériau, **caractérisé en ce que** un faisceau d'électrons (1) est dirigé sur le matériau (4) avec une distance de la buse de sortie (3) entre le faisceau d'électrons (1) et le matériau (4), en fonction du procédé, de 0,3 mm à 50 mm, de préférence inférieure à 10 mm, et avec un angle de 15° bis 90° avec la surface du matériau (4)
et simultanément, un jet de gaz (5) concentré avec vitesse de flux élevée est soufflé sur la phase de fusion à la phase d'évaporation (6) produite par le faisceau d'électrons (1) avec un angle inférieur à 90° vers le faisceau d'électrons (1) et le matériau (4), de telle sorte que le faisceau d'électrons (1) et le jet de gaz (5) possèdent la distance la plus faible d'abord dans la zone de la phase de fusion à la phase d'évaporation (6), et **en ce que**, au-dessus, la distance croît entre la buse de sortie (3) et la bus de gaz de pression (8),
le matériau (4) étant amené, de façon concentrée localement avec le faisceau d'électrons (1), à la fusion et à l'évaporation sur la totalité de l'épaisseur de matériau,
le jet de gaz (5) se composant d'un gaz inerte ou d'un mélange de gaz inertes, lequel est conduit sur la totalité de l'épaisseur du matériau (4) fondu jusqu'à évaporé, et expulse la phase liquide et gazeuse.

3. Procédé selon l'une des revendications 1 ou 2, **caractérisé en ce que**
au moins dans la zone de la phase de fusion de la pièce à usiner (4), ou du faisceau d'électrons (1) dans la zone de matériau, une différence de pression de 50 mbar à 800 mbar est produite entre les surfaces de pièce à usiner supérieure et inférieure, afin d'entraîner une aspiration du jet de gaz (5), de la phase de fusion à la phase d'évaporation (6) de la pièce à usiner (4), ainsi que de la scorie (7) du jeu de coupe vers le dessous de la pièce à usiner (4).

4. Dispositif pour la réalisation du procédé selon la revendication 3, se composant d'une unité d'entraînement, de guidage et d'alimentation en énergie pour un générateur d'énergie thermique et de jet de gaz, ainsi que de supports de pièce avec entonnoir d'aspiration, étant fixée une buse de gaz de pression (8), laquelle est raccordée à un dispositif de gaz de pression, sur un canon à électrons hors vide (2) de façon déplaçable dans la zone de la buse de sortie (3) du faisceau d'électrons,
l'axe de la buse de sortie (3) et l'accès de la buse de gaz de pression (8) comprenant un angle de 0° à 90° et l'axe de la buse de sortie (3) comprenant un angle de 15° à 90° avec la surface du matériau, **caractérisé en ce que**
les bouches de la buse de sortie et de la buse de gaz de pression (3, 8) sont décalées l'une par rapport à l'autre, elles possèdent une distance inférieure à 10 mm et leurs distances avec la surface de la pièce à usiner est réglable en hauteur sur une plage de 0,3 mm à 50 mm,
et **en ce que**, pour de petites pièces à usiner (4), un entonnoir d'aspiration s'étend sur la surface inférieure totale de la pièce à usiner (4) ou du support de pièce et est raccordé avec celle-ci par une baguette d'étanchéité élastique résistante à la chaleur, le canon à électrons hors vide (2) étant disposé de façon stationnaire et le mouvement d'avance étant effectué par le mouvement de la pièce à usiner (4) ou du support de pièce conjointement à celui de l'aspiration, au moyen d'un entraînement biaxial.

5. Dispositif pour la réalisation du procédé selon la revendication 3, se composant d'une unité d'entraînement, de guidage et d'alimentation en énergie pour un générateur d'énergie thermique et de jet de gaz, ainsi que de supports de pièce avec entonnoir d'aspiration, étant fixée une buse de gaz de pression (8), laquelle est raccordée à un dispositif de gaz de pression, sur un canon à électrons hors vide (2) de façon déplaçable dans la zone de la buse de sortie (3) du faisceau d'électrons,
l'axe de la buse de sortie (3) et l'accès de la buse de gaz de pression (8) comprenant un angle de 0° à 90° et l'axe de la buse de sortie (3) comprenant un angle de 15° à 90° avec la surface du matériau, **caractérisé en ce que**
les bouches de la buse de sortie et de la buse de gaz de pression (3, 8) sont décalées l'une par rapport à l'autre, elles possèdent une distance inférieure à 10 mm et leurs distances avec la surface de la pièce à usiner est réglable en hauteur sur une plage de 0,3 mm à 50 mm,
et **en ce que**, pour les grandes pièces à usiner (4), l'entonnoir d'aspiration est entraîné avec le mouvement de coupe du canon à électrons hors vide (2) au moyen d'une liaison avec celui-ci ou d'un entraînement commandé et une étanchéification du jeu de mouvement entre le bord supérieur de l'entonnoir d'aspiration et le support de pièce est réalisée par plusieurs rangées de filaments juxtaposées élastiques sur l'entonnoir d'aspiration.

6. Dispositif pour la réalisation du procédé selon la revendication 3,
se composant d'une unité d'entraînement, de guidage et d'alimentation en énergie pour un générateur d'énergie thermique et de jet de gaz, ainsi que de supports de pièce avec entonnoir d'aspiration, étant fixée une buse de gaz de pression (8), laquelle est raccordée à un dispositif de gaz de pression, sur un canon à électrons hors vide (2) de façon déplaçable dans la zone de la buse de sortie (3) du faisceau d'électrons,
l'axe de la buse de sortie (3) et l'axe de la buse de gaz de pression (8) comprenant un angle de 0 ° à 90 ° et l'axe de la buse de sortie (3) comprenant un angle de 15° à 90° avec la surface du matériau, **caractérisé en ce que** les bouches de la buse de sortie et de la buse de gaz de pression (3, 8) sont décalées l'une par rapport à l'autre, elles possèdent une distance inférieure à 10 mm et leurs distances avec la surface de la pièce à usiner est réglable en hauteur sur une plage de 0,3 mm à 50 mm
et **en ce que**, pour les grandes pièces à usiner, le canon à électrons hors vide (2) est, avec l'entonnoir d'aspiration, déplaçable sur un axe horizontal, et la pièce à usiner (4) ou le support de pièce sur un deuxième axe horizontal, perpendiculaire au premier, au moyen d'entraînements correspondants,
l'étanchéification du jeu de mouvement droit pour l'entonnoir d'aspiration est effectué sous la pièce à usiner (4) ou le support de pièce par deux bandes d'étanchéité élastiques se chevauchant et la partie supérieure de l'entonnoir d'aspiration est disposée entre celles-ci, de telle sorte que les bandes d'étanchéité comprennent l'entonnoir d'aspiration de façon étanche et que le mouvement de coupe est effectué par la superposition des deux mouvements horizontaux au moyen d'une commande.
